# EUROPÄISCHE PATENTSCHRIFT

(11) **EP 0 459 312 B1**
(45) Veröffentlichungstag und Bekanntmachung des Hinweises auf die Patenterteilung: **11.09.1996**
(21) Anmeldenummer: 91108417.6
(22) Anmeldetag: 24.05.1991
(51) Int. Cl.: G01R 19/165, G01R 19/00

(54) **Prellfreie Vergleichsschaltung**
Bounce-free comparing circuit
Circuit de comparaison sans rebondissement

(30) Priorität: 31.05.1990 DE 4017486
(43) Veröffentlichungstag der Anmeldung: 04.12.1991
(73) Patentinhaber: DEUTSCHE THOMSON-BRANDT GMBH, 78048 Villingen-Schwenningen (DE)
(72) Erfinder: Gleim, Günter, Dipl.-Ing., W-7730 VS-Villingen (DE); Füldner, Friedrich, Dipl.-Ing., W-7730 Villingen-Schwenningen (DE); Rekla, Bernd, W-7730 VS-Villingen (DE)

(56) Entgegenhaltungen:
- EP-A- 0 286 282
- DE-A- 2 800 435
- FR-A- 2 554 989
- US-A- 4 929 851

## Beschreibung

Die Erfindung betrifft eine prellfreie Vergleichsschaltung gemäß dem Oberbegriff des Anspruchs 1. Dieser Oberbegriff wurde aus der Druckschrift DE-A-28 00 435 abgeleitet.

Aus U. Tietze, Ch. Schenk, Halbleiter-Schaltungstechnik, 4. Auflage, Springer-Verlag, Berlin, Heidelberg, New York, 1978 sind auf Seite 411 bis 418 Komparatoren beschrieben, die ihre Ausgangsspannung von einem niederen Wert auf einen hohen Wert sprungartig erhöhen, wenn das Eingangssignal einen vorgegebenen Referenzwert überschreitet.

Aus der EP-A-O 286 282 ist eine Vergleichsschaltung bekannt, die ein Eingangssignal mit einer Referenzgröße vergleicht. Dem einen Eingang eines Verstärkers wird eine erste Referenzgröße zugeführt, während an dessen anderem Eingang das Eingangssignal liegt. Der Ausgang des Verstärkers ist über einen Integrator mit dem einen Eingang eines Vergleichers verbunden, an dessen anderem Eingang eine zweite Referenzgröße liegt.

In vielen Anwendungsfällen ist aber das Eingangssignal des Komparators von einer hochfrequenten Schwingung überlagert. So ist z.B. sowohl das Fokus- als auch das Spurfehlersignal eines CD-Spielers von einer hochfrequenten Schwingung überlagert, die von den Daten verursacht werden, die auf der Platte, der sogenannten Compact-Disc, aufgezeichnet sind.

Wegen dieser überlagerten hochfrequenten Schwingungen springt die Spannung am Ausgang eines Komparators in der Nähe der Schaltschwelle - wenn das Eingangssignal den Referenzwert erreicht - mehrmals zwischen dem hohen und dem niederen Pegel hin und her. Es entstehen die sogenannten Preller.

Um Preller zu unterdrücken, kann zwischen den Eingängen des Komparators ein Kondensator vorgesehen werden, der die hochfrequenten Schwingungen kurzschließt. Diese Lösung läßt sich jedoch nicht als integrierten Schaltkreis herstellen, weil eine Kapazität in der benötigten Größe mit den heutigen Mitteln der Technik nicht in einen integrierten Schaltkreis eingebaut werden kann.

Es ist daher Aufgabe der Erfindung, eine zwar prellfreie aber dennoch als integrierten Schaltkreis herstellbare Vergleichsschaltung anzugeben.

Die Erfindung löst diese Aufgabe gemäß der im Anspruch 1 angegebenen Lösung.

Anhand der Figuren wird die Erfindung zuerst beschrieben und anschließend erläutert.

Es zeigen
- Figur 1: ein erstes Ausführungsbeispiel
- Figur 2: ein zweites Ausführungsbeispiel
- Figur 3: ein drittes Ausführungsbeispiel der Erfindung
- Figur 4: Impulsdiagramme zur Erläuterung der erfindungsgemäßen Vergleichsschaltung aus Figur 1
- Figur 5: Impulsdiagramme zur Erläuterung der in Figur 2 abgebildeten Ausgestaltung der Erfindung.

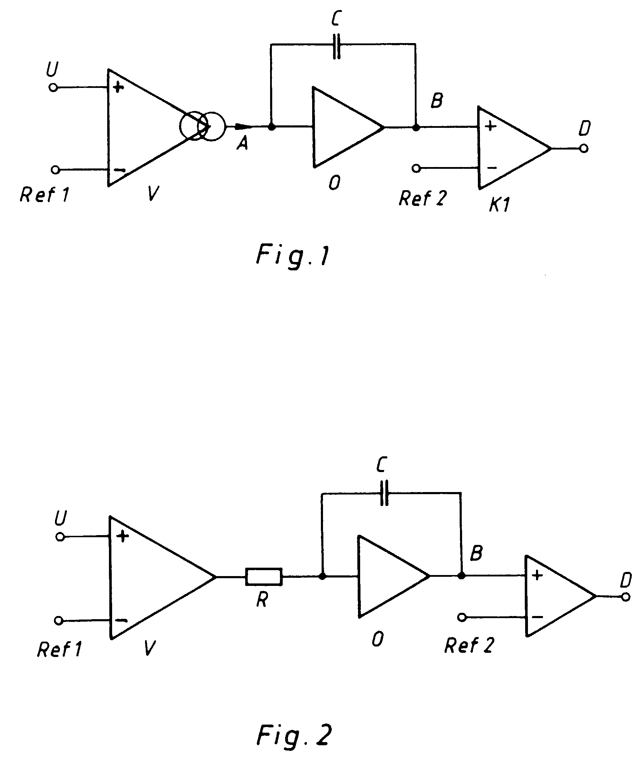

In der Figur 1 wird das von hochfrequenten Schwingungen überlagerte Eingangssignal U dem nichtinvertierenden Eingang eines Transduktanzverstärkers V zugeführt, an dessen invertierendem Eingang eine Referenzgröße Ref1 liegt. Der Ausgang des Transduktanzverstärkers V ist mit dem Eingang eines Integrators I verbunden, bestehend aus einem Operationsverstärker O, dessen Ausgang über eine Kapazität C auf seinen invertierenden Eingang rückgekoppelt ist. Der Ausgang des Integrators I ist mit dem nichtinvertierenden Eingang eines Vergleichers K1 verbunden, an dessen invertierendem Eingang eine Referenzgröße Ref2 liegt.

Ein Transduktanzverstärker ist ein Verstärker, der eine Spannung an seinem Eingang in einen Strom an seinem Ausgang wandelt. Er kann in erster Näherung z.B. durch einen gewöhnlichen Verstärker mit einem an seinem Ausgang nachgeschalteten Serienwiderstand ersetzt werden.

Das in Figur 2 abgebildete Ausführungsbeispiel unterscheidet sich vom in Figur 1 gezeigten Ausführungsbeispiel dadurch, daß der Transduktanzverstärker aus einem Verstärker V und einem an seinem Ausgang nachgeschalteten Serienwiderstand R aufgebaut ist.

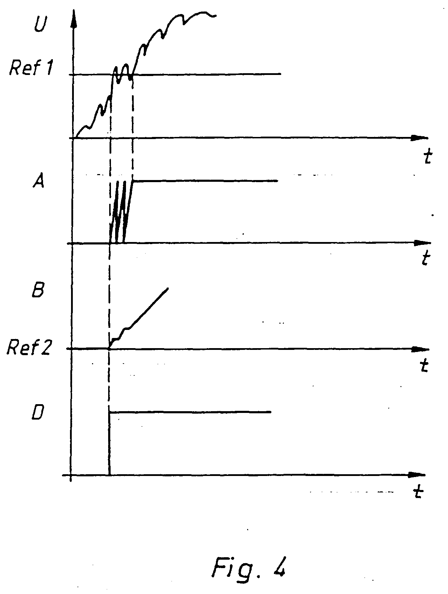

Anhand der in Figur 4 gezeigten Diagramme wird die in Figur 1 gezeigte Vergleichsschaltung erläutert.

Wenn das Eingangssignal U, das von hochfrequenten Schwingungen überlagert ist, den Referenzwert Ref1 erreicht, beginnt der Transduktanzverstärker V Strom an den Integrator I zu leiten. Jedoch treten im Ausgangsstrom A des Transduktanzverstärkers V in der Nähe der Schaltschwelle die unerwünschten Preller auf. Durch Integration des Ausgangsstromes A im Integrator I wird eine prellfreie Spannung B am Ausgang des Integrators erzeugt. Wenn diese prellfreie Spannung B den Referenzwert Ref2, der z.B. Null sein kann, erreicht, ändert der Vergleicher K1 sein Ausgangssignal D sprungartig ohne Preller. Weil die Kapazität C im Gegenkopplungszweig des Integrators I aber wesentlich kleiner ist als eine anstelle des Integrators am Eingang eines Komparators vorzusehende Kapazität, läßt sich die Erfindung als integrierter Schaltkreis herstellen.

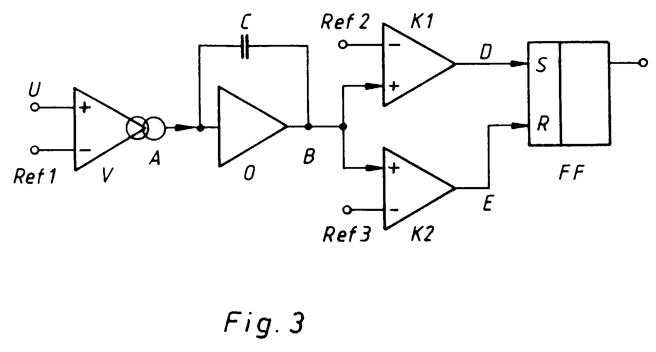

In der Figur 3 ist eine Ausgestaltung der Erfindung gezeigt, die sich von der Vergleichsschaltung aus Figur 1 dadurch unterscheidet, daß sie durch einen weiteren Vergleicher K2 und ein RS-Flip-Flop FF ergänzt ist.

Der Ausgang des Integrators I ist mit dem nichtinvertierenden Eingang des weiteren Vergleichers K2 verbunden, an dessen invertierendem Eingang eine Referenzgröße Ref3 liegt, die größer als die Referenzgröße Ref2 gewählt ist. Der Ausgang des Vergleichers K1 ist mit dem Setzeingang, der Ausgang des Vergleichers K2 dagegen mit dem Rücksetzeingang des RS-Flip-Flops FF verbunden.

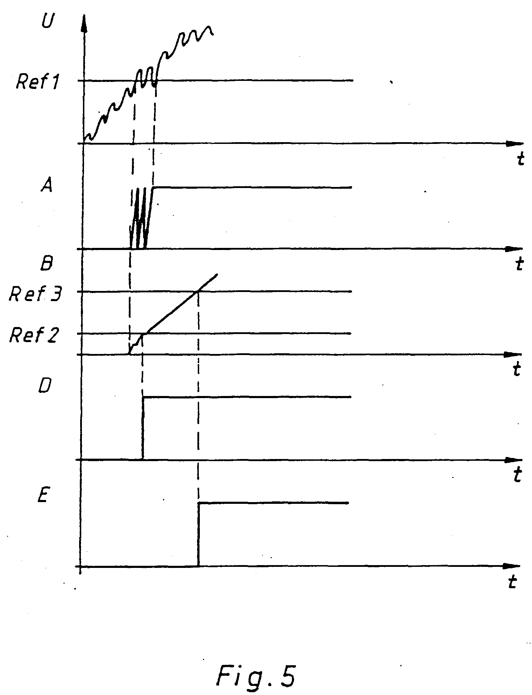

In Figur 5 sind die zugehörenden Diagramme gezeichnet.

Wenn die Spannung B am Ausgang des Integrators I den Referenzwert Ref2 erreicht, wird das RS-Flip-Flop FF gesetzt. Erreicht die Spannung B des Integrators I den Referenzwert Ref3, so wird das RS-Flip-Flop zurückgesetzt.

Die Erfindung ist für Vergleichsschaltungen geeignet, die einerseits eine Kapazität benötigen, um ein prellfreies Ausgangssignal zu erzeugen, sich aber andererseits als integrierten Schaltkreis herstellen lassen. Derartige Vergleichsschaltungen können z.B. im Spurregelkreis und im Fokusregelkreis optischer Aufzeichnungs- und Wiedergabegeräte vorteilhaft eingesetzt werden.

## Patentansprüche

1. Prellfreie Vergleichsschaltung, die ein Eingangssignal (U) mit einer ersten Referenzgröße (Ref1) vergleicht und die einen Verstärker (V) und einen Integrator (I) aufweist, wobei der Ausgang des Verstärkers (V) mit dem Eingang des Integrators (I) verbunden ist und wobei der Verstärker (V) ein sogennanter Transduktanzverstärker ist, der eine Spannung an seinem Eingang in einen Strom an seinem Ausgang wandelt, dadurch gekennzeichnet, daß am einen Eingang des Verstärkers (V) die erste Referenzgröße (Ref1) und am anderen Eingang des Verstärkers (V) das Eingangssignal (U) liegt, und daß der Ausgang des Integrators (I) mit dem einen der beiden Eingänge eines ersten Vergleichers (K1) verbunden ist, an dessen anderem Eingang eine zweite Referenzgröße (Ref2) Liegt und dessen Ausgang den Ausgang der Vergleichsschaltung bildet.

2. Vergleichsschaltung nach Anspruch 1, **dadurch gekennzeichnet,** daß der Transduktanzverstärker aus einem Verstärker (V) und einem dessen Ausgang nachgeschalteten Serienwiderstand (R) aufgebaut ist.

3. Vergleichsschaltung nach Anspruch 1 oder 2, **dadurch gekennzeichnet**, daß der Ausgang des Integrators (I) zusätzlich mit einem ersten Eingang eines zweiten Vergleichers (K2) verbunden ist, an dessen anderem Eingang eine dritte Referenzgröße (Ref3) liegt, und daß der jeweilige Ausgang des ersten und zweiten Vergleichers (K1, K2) mit je einem Eingang einer bistabilen Kippstufe (FF) verbunden ist, deren Ausgang den Ausgang der Vergleichsschaltung bildet.

## Claims

1. A bounce-free comparison circuit which compares an input signal (U) with a first reference magnitude (Ref 1) and which comprises an amplifier (V) and an integrator (I), the output of the amplifier (V) being connected to the input of the integrator (I) and the amplifier (V) being a so-called transconductance amplifier which converts a voltage at its input into a current at its output, characterised in that the first reference magnitude (Ref 1) is applied to the first input of the amplifier (V) and the input signal (U) is applied to the other input of the amplifier (V), and in that the output of the integrator (I) is connected to the first of the two inputs of a first comparator (K1) to the other input of which is applied a second reference magnitude (Ref 2) and the output of which forms the output of the comparison circuit.

2. A comparison circuit according to claim 1, characterised in that the transconductance amplifier is constructed of an amplifier (V) and a serial resistance (R) connected to the output thereof.

3. A comparison circuit according to claim 1 or 2, characterised in that the output of the integrator (I) is additionally connected to a first input of a second comparator (K2), to the other input of which is applied a third reference magnitude (Ref 3), and in that the outputs of the first and second comparator (K1, K2) are each connected to a respective input of a bistable flip-flop (FF), the output of which forms the output of the comparison circuit.

## Revendications

1. Circuit de comparaison sans rebondissement servant à comparer un signal d'entrée (U) avec une première valeur de référence (Ref1), et intégrant un amplificateur (V) et un intégrateur (I), sachant que la sortie dudit amplificateur (V) est raccordée à l'entrée dudit intégrateur (I), et sachant en outre que ledit amplificateur (V) est un amplificateur transducteur qui transforme une tension appliquée à son entrée en un courant à sa sortie, circuit de comparaison **caractérisé en ce que** la première valeur de référence (Ref1) est appliquée à l'une des entrées de l'amplificateur (V) et que le signal d'entrée (U) est appliqué à l'autre entrée dudit amplificateur, et caractérisé également en ce que la sortie de l'intégrateur (I) est connectée à l'une des deux entrées d'un premier comparateur (K1) dont l'autre entrée fournit une seconde valeur de référence (Ref2) et dont la sortie constitue la sortie du circuit de comparaison.

2. Circuit de comparaison selon la revendication 1 **caractérisé en ce que** l'amplificateur transducteur est constitué d'un amplificateur (V) et d'une résistance série (R) montée en aval de la sortie de celui-ci.

3. Circuit de comparaison selon l'une quelconque des revendications 1 ou 2 **caractérisé en ce que** la sortie de l'intégrateur (I) est également connectée à une première entrée d'un second comparateur (K2) dont la seconde entrée fournit une troisième valeur de référence (Ref3), et que les sorties correspondantes des premier et second comparateurs (K1, K2) sont connectées respectivement à l'une des entrées d'une bascule bistable (FF) dont la sortie constitue la sortie du circuit de comparaison.
